# EUROPÄISCHE PATENTSCHRIFT

(11) **EP 1 381 706 B1**
(45) Veröffentlichungstag und Bekanntmachung des Hinweises auf die Patenterteilung: **22.09.2004**
(21) Anmeldenummer: 02732501.8
(22) Anmeldetag: 20.03.2002
(51) Int. Cl.: C23C 14/02, C23C 14/20, F16L 9/12, F24D 3/14

(54) **VERFAHREN ZUR HERSTELLUNG VON ENDLOSEN KUNSTSTOFF-HOHLPROFILEN UND ENTSPRECHENDE HOHLPROFILE**
METHOD FOR PRODUCTION OF ENDLESS PLASTIC HOLLOW PROFILES AND CORRESPONDING PROFILES
PROCEDE DE REALISATION DE PROFILES CREUX EN PLASTIQUE CONTINUS ET PROFILES CORRESPONDANTS

(30) Priorität: 24.03.2001 DE 10114485
(43) Veröffentlichungstag der Anmeldung: 21.01.2004
(73) Patentinhaber: I V T Installations-und Verbindungstechnik GmbH & Co. KG, 91189 Rohr (DE)
(72) Erfinder: HENNIG, Christoph, 91126 Schwabach (DE)
(74) Vertreter: Brose, Manfred, Dr.
(86) Internationale Anmeldenummer: PCT/EP2002/003056
(87) Internationale Veröffentlichungsnummer: WO 2002/077315

(56) Entgegenhaltungen:
- WO-A-02/01115
- DE-A- 3 320 273

## Beschreibung

Die Erfindung betrifft ein verfahren zur Herstellung von endlosen Kunststoff-Hohlprofilen, insbesondere Rohren, sowie ein Kunststoff Hohlprofil, bestehend aus mehreren Produktionsstufen für das Kunststoffrohr und einer Stufe zur Aufbringung eines äußeren Metallmantels.

Beschichtungen von Kunststoffen sind insbesondere in der Verpackungsindustrie mittels der Dünnschichttechnologie bekannt, Dabei wird eine minimale metallische Schicht einseitig auf eine Kunststoff-Folie mit hoher Geschwindigkeit aufgetragen. Für die Umfangsfläche von Hohlprofilen, insbesondere von Rohren, auf die eine Schicht mit gleichbleibender Dicke aufgetragen werden soll, ist dieses bekannte Verfahren nicht anwendbar, da nach diesem Verfahren Folien immer nur einseitig beschichtet werden können.

Der Erfindung liegt daher die Aufgabe zugrunde, für Hohlprofile ein Verfahren zu schaffen, mit dem bei hoher Produktionsgeschwindigkeit eine technisch nutzbare metallische Beschichtung nach der Dünnschichttechnologie hergestellt werden kann.

Diese Aufgabe wird nach der Erfindung dadurch gelöst, dass das gattungsgemäße Verfahren auch nach dem Kennzeichen von Anspruch 1 ausgelegt wird.

In den Unteransprüchen werden Ausgestaltungen und Fortbildungen der Erfindung beansprucht.

In den Zeichnungen wird als Beispiel eine Vorrichtung zur Durchführung des Verfahrens beschrieben. Es zeigen:
- Fig. 1: eine schematische Ansicht einer Beschichtungsanlage, wobei das Rohr aus einer Extrusionsanlage austritt,
- Fig. 2: eine schematische Ansicht einer Beschichtungsanlage, wobei das Rohr von einer Haspel abgewickelt wird, und
- Fig. 3: den schematischen Aufbau der Beschichtungsstufe.

Eine bekannte Vorrichtung 1 zur Herstellung eines Kunststoffrohres t beispielsweise aus Polyethylen besteht aus einem Extruder 11, einem Werkzeug 12, einer Kalibrierstrecke 13, einer Kühlstrecke 14, einem eventuell gewünschten Drucker 15, einer Abzugstrecke 16 um das Kunststoffrohr t in die Richtung des Pfeiles a zu ziehen, einem Abschneider 17 und einer Haspel 18, um sehr lange Rohrstücke aufzuwickeln .

Nach der Erfindung wird nun, vorzugsweise zwischen der Kühlstrecke 14 und dem Drucker 15 ein System von drei Stationen für die Beschichtung des Kunststoffrohres t mit einem Metall eingefügt.

Die Rohroberfläche ist nach dem Austritt des Rohres t aus dem Werkzeug 12 kraterförmig uneben und in diesem Zustand nicht für eine unmittelbare Beschichtung geeignet. Daher durchläuft das Rohr t zunächst eine Glättungsstrecke 22, in der ein Flüssigpolymer auf die Rohroberfläche aufgetragen wird. In der nachfolgenden Trockungsstrecke 21 wird die aufgetragene Polymerschicht getrocknet. Danach ist die Rohroberfläche für eine Beschichtung geeignet.

Anstelle des Auftragens eines Flüssigpolymers kann die Rohroberfläche auch durch eine Beflammung geglättet werden.

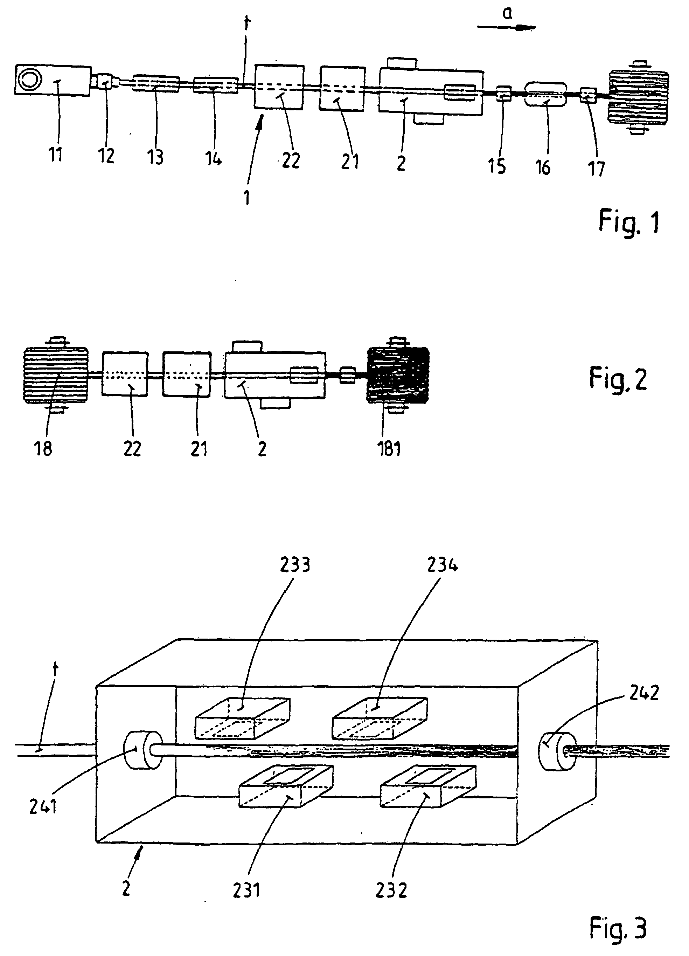

Anschließend durchläuft das so vorbehandelte Rohr t die Beschichtungsstrecke 2. In Figur 3 ist schematisch der innere Aufbau der Beschichtungsstrecke 2 dargestellt. Im Inneren der Beschichtungsstrecke 2 befinden sich beispielsweise vier Beflammungssschiffchen 231, 232,233, 234, die jeweils um einen Winkel von 90 Grad gegeneinander versetzt sind, damit eine gleichmäßige Beschichtung des Rohres t erfolgt. Es ist jedoch auch möglich, die Schiffchen beweglich zu lagern und sie bei der Beschichtung um das Rohr t umlaufen zu lassen. Die Beflammungsschiffchen werden elektrisch beheizt und verdampfen das Beschichtungsmetall, z.B. Aluminium oder Kupfer, so dass dieses in die Gasphase überführt wird und sich auf dem Rohr t niederschlägt. In der Beschichtungsstrecke 2 herrscht vorzugsweise ein Unterdruck. Wegen der sehr glatten Oberfläche des Rohres t sind auch keine aufwendigen Abdichtungen notwendig.

Eine Flüssigkeitsschleuse, wie sie für Vakuumbehälter in kontinuierlichen Fertigungsprozessen bekannt ist, wäre auch in hohem Maße für eine Beschichtung im Vakuum von Nachteil, da die Oberfläche des Rohres bei einer Benetzung durch die Flüssigkeit nicht mehr beschichtungsfähig ist. Bei den Dichtungen 241, 242 handelt es sich daher um Kunststoffdichtungen aus elastischem Material.

Bei der vorbeschriebenen Vorrichtung 1 ist es notwendig, die von dem Rohr t durchlaufenen verschiedenen Längen der Glättungsstrecke 22, Trocknungsstrecke 21 und Beschichtungsstrecke 2 so auszulegen, dass diese bei der vorgegebenen Produktions- bzw. Extrusionsgeschwindigkeit ihre Aufgaben erfüllen können.

In Figur 2 ist eine Vorrichtung 1 wiedergegeben, bei der das zu beschichtende Rohr t bereits vorhanden und auf einer Haspel 18 aufgewickelt ist. Es durchläuft dann nur die Strecke 22, 21, 2. In diesem Fall ist die Durchlaufgeschwindigkeit durch die Strecken 22, 21,2 nicht mehr von einer Produktionsgeschwindigkeit abhängig, sondern kann ausschließlich nach den Forderungen der drei Strecken 22, 21, 2 ausgelegt werden.

Es ist sinnvoll, die drei Strecken 22, 21, 2 zu einer Einheit zusammenzufassen. In diesem Fall sind nur zwei Dichtungen erforderlich .

### Bezugszeichenliste

- 1: Vorrichtung
- 11: Extruder
- 12: Werkzeug
- 13: Kalibrierstrecke
- 14: Kühlstrecke
- 15: Drucker
- 16: Abzugsstrecke
- 17: Abschneider
- 18: Haspel
- 181: Haspel
- 2: Beschichtungsstrecke
- 21: Trocknungsstrecke
- 22: Glättungsstrecke
- 231: Beflammungsschiffchen
- 232: Beflammungsschiffchen
- 233: Beflammungsschiffchen
- 234: Beflammungsschiffchen
- 241: Dichtung
- 242: Dichtung

- t: Kunststoffrohr
- a: Pfeil der Bewegungsrichtung

## Patentansprüche

1. Verfahren zur Herstellung von endlosen Kunststoff-Hohlprofilen, insbesondere Rohren, wobei das Kunststoffrohr zuerst geglättet und anschließend ein Metall durch Verdampfen im Vakuum auf das Rohr als Metallschicht aufgebracht wird,
**dadurch gekennzeichnet, daß**
auf das geglättete Rohr zuerst ein Flüssigpolymer und anschließend die sich mit dem Flüssigpolymer innig verbindende Metallschicht in einer zusammen gasdichten Schichtdicke aufgebracht werden.

2. Kunststoff-Hohlprofil, insbesondere Rohr, mit einer äußeren Metallschicht nach dem Verfahren von Anspruch 1,
**gekennzeichnet durch**
eine Schicht aus einem Flüssigpolymer zwischen dem geglätteten Rohr und der Metallschicht.

## Claims

1. Method of producing endless plastic hollow profiles, particularly tubes, wherein the plastic tube is initially smoothed and subsequently a metal is applied to the tube as a metal layer by evaporation in vacuum, **characterised in that** initially a liquid polymer and subsequently the metal layer, which intimately connects with the liquid polymer, are applied to the smoothed tube in a mutually gas-tight layer thickness.

2. Plastic hollow profile, particularly tube, with an outer metal layer according to the method of claim 1, **characterised by** a layer of a liquid polymer between the smoothed tube and the metal layer.

## Revendications

1. Procédé de fabrication de profilés creux sans fin en matière plastique, en particulier de tubes, le tube en matière plastique étant d'abord lissé et ensuite un métal étant appliqué sous forme de couche métallique sur le tube par évaporation sous vide, **caractérisé en ce que** sont appliqués sur le tube lissé, en une épaisseur de couche conjointement étanche aux gaz, d'abord un polymère liquide et ensuite la couche métallique se liant intimement au polymère liquide.

2. Profilé creux en matière plastique, en particulier tube, avec une couche métallique extérieure suivant le procédé de la revendication 1, **caractérisé par** une couche en un polymère liquide entre le tube lissé et la couche métallique.
